# EUROPÄISCHE PATENTSCHRIFT

(11) **EP 0 713 634 B1**
(45) Veröffentlichungstag und Bekanntmachung des Hinweises auf die Patenterteilung: **09.04.1997**
(21) Anmeldenummer: 94922849.8
(22) Anmeldetag: 08.08.1994
(51) Int. Cl.: H05K 5/02, H05K 7/14

(54) **ELEKTRONISCHES GERÄT**
ELECTRONIC DEVICE
APPAREIL ELECTRONIQUE

(30) Priorität: 11.08.1993 DE 9312000 U
(43) Veröffentlichungstag der Anmeldung: 29.05.1996
(73) Patentinhaber: SIEMENS AKTIENGESELLSCHAFT, 80333 München (DE)
(72) Erfinder: HAHN, Karl-Heinz, D-76344 Eggenstein-Leopoldshafen (DE); SAISILA, Chartchai, D-76761 Rülzheim (DE)
(86) Internationale Anmeldenummer: DE9400915
(87) Internationale Veröffentlichungsnummer: WO9505062

(56) Entgegenhaltungen:
- EP-A- 0 575 214
- CH-A- 215 699
- DE-U- 9 213 496
- FR-A- 2 365 273

## Beschreibung

Die Erfindung betrifft ein elektronisches Gerät mit einem im wesentlichen zweiteiligen Gehäuse, das als Handheld-Gerät verwendbar ist.

In der Automatisierungstechnik, insbesondere bei numerischen Steuerungen, werden häufig externe, mit der Steuerung über ein flexibles Kabel verbundene Bedienfelder zur Eingabe von Steuerbefehlen eingesetzt. Dies ist vorteilhaft, wenn ein Programmierer, z. B. bei einem Roboter zum Beobachten der Verfahrstellungen, häufig den Standort wechseln muß oder wenn eine Steuerung aus Platzgründen ergonomisch ungünstig oder schwer zugänglich angeordnet werden muß. Die Beweglichkeit eines derartigen Bedienfeldes hat aber den Nachteil, daß es zum einen leicht auf den Boden fallen und beschädigt werden kann und zum anderen bei der Bedienung auf eine feste Unterlage gelegt oder mit der einen Hand festgehalten werden muß. In vielen Fällen wäre daher anstatt des beweglichen Bedienfeldes ein fest eingebautes Bedienfeld wünschenswert.

Der Erfindung liegt die Aufgabe zugrunde, ein elektronisches Gerät mit einem Gehäuse zu schaffen, das sowohl als bewegliches als auch als fest eingebautes Gerät betreibbar und das auf einfache Weise von einer Betriebsart auf die andere umrüstbar ist.

Zur Lösung dieser Aufgabe weist das erfindungsgemäße elektronische Gerät die in Anspruch 1 genannten Merkmale auf. Vorteilhafte Weiterbildungen der Erfindung sind in den Unteransprüchen angegeben.

Die Erfindung hat den Vorteil, daß zum Einbau eines bisher als Handheld-Gerät betriebenen elektronischen Gerätes weder zusätzliche Teile benötigt noch irgendwelche Teile übriggelassen werden müssen. Damit ist ein Verlust derartiger Teile bei längerem Gebrauch in derselben Betriebsart ausgeschlossen. Eine umlaufende Dichtung auf der Rückseite des Randes am Gehäusevorderteil vermeidet vorteilhaft das Eindringen von Staub oder Feuchtigkeit in das elektronische Gerät. Bedien- und Anzeigeelemente können gut sichtbar und ergonomisch günstig auf der Vorderseite des Gehäusevorderteils untergebracht werden. Zur Befestigung der Gehäuserückwand an dem Gehäusevorderteil können handelsübliche Schrauben verwendet werden, die ohne ein Spezialwerkzeug betätigbar sind.

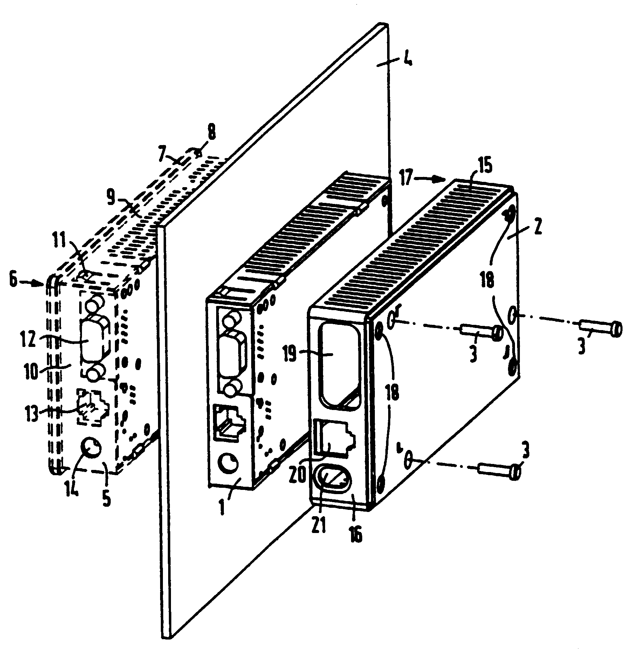

Anhand der Figur, in der ein Ausführungsbeispiel der Erfindung dargestellt ist, werden im folgenden die Erfindung sowie Ausgestaltungen und Vorteile näher erläutert.

Die Figur zeigt in einer Explosionsdarstellung ein Gehäusevorderteil 1, eine Gehäuserückwand 2, Befestigungselemente 3 und eine Platte 4. Da das Gehäusevorderteil 1 des elektronischen Gerätes teilweise durch die Platte 4 verdeckt ist, wurde daneben ein zweites Gehäusevorderteil 5 mit durchbrochenen Linien dargestellt, um alle Elemente sichtbar zu machen. Die beiden Gehäusevorderteile 1 und 5 sind identisch und bei einem elektronischen Gerät nur einmal vorhanden. An einer Vorderseite 6 des Gehäusevorderteils 5 können Bedien- oder Anzeigeelemente angeordnet werden. Diese sind sowohl bei einem elektronischen Gerät als Handheld-Gerät als auch in eingebautem Zustand des elektronischen Geräts zugänglich. Der Vorderseite 6 benachbart weist das Gehäusevorderteil 5 einen umlaufenden Rand 7 auf, dessen Rückseite mit einer Dichtung 8 belegt ist. Der umlaufende Rand 7 ragt seitlich über hintere Seitenwände 9 und 10 sowie zwei weitere, in der Zeichnung verdeckte Seitenwände hinaus. An der Seitenwand 9 und der gegenüberliegenden, nicht sichtbaren Seitenwand des Gehäusevorderteils 5 ist jeweils ein Rastelement 11 vorgesehen, das aus der Ebene der Seitenwand seitlich hervorsteht und federnd aufgehängt ist. An der Seitenwand 10 sind Anschlußstellen 12, 13 und 14 für externe Leitungen des elektronischen Geräts vorgesehen. Die Gehäuserückwand 2 ist becherartig derart ausgeführt, daß sie mit ihren Seitenwänden, von denen in der Figur lediglich die Seitenwände 15 und 16 sichtbar sind, über die Seitenwände des Gehäusevorderteils 1 geschoben werden kann. Um das elektronische Gerät als Handheld-Gerät zu montieren, wird die Gehäuserückwand 2 einfach über die Seitenwände des Gehäusevorderteils 5 geschoben, so daß die Vorderkante 17 der Seitenwände der Gehäuserückwand 2 auf dem Rand 7 des Gehäusevorderteils 5 zu liegen kommt. Gehäuserückwand 2 und Gehäusevorderteil 5 können durch Einsetzen und Anziehen der Schrauben 3 aneinander befestigt werden. Die Gehäuserückwand 2, die nun als Bodenplatte dient, ist mit Gummifüßen 18 zur besseren Auflage auf einer Tischfläche versehen. Zur Umrüstung eines Handheld-Gerätes zu einem Einbaugerät werden die Schrauben 3 gelöst, die Gehäuserückwand 2 abgenommen, das Gehäusevorderteil 5 in einen geeigneten Ausschnitt einer Platte 4 eingeschoben - durch die Rastelemente 11 werden Gehäusevorderteil 5 mit Platte 4 leicht zusammengehalten -, die Gehäuserückwand 2 wieder aufgesetzt und mit den Schrauben 3 befestigt. Wenn Dicke der Platte 4 und Abstand des Rastelements 11 zur Dichtung 8 übereinstimmen, rastet dieses vorteilhaft ein. Das elektronische Gerät kann somit auf einfache Weise in einer Schalttafel oder einer Schranktür integriert werden. Ausnehmungen 19, 20 und 21 in der Gehäuserückwand 2 sind derart ausgeführt, daß externe Leitungen an die Anschlußstellen 12, 13 und 14 sowohl im eingebauten Zustand als auch in der Handheld-Version des elektronischen Gerätes geführt werden können.

## Patentansprüche

1. Elektronisches Gerät mit einem Gehäuse, bestehend aus
- einem Gehäusevorderteil (5) mit einem der Vorderseite (6) des Gehäuses benachbarten Rand (7), der in einer Ebene verläuft und die hinteren Seitenwände (9, 10) des Gehäusevorderteils (5) seitlich überragt,
- einer becherartigen Gehäuserückwand (2), mit deren Seitenwänden (15, 16) die hinteren Seitenwände (9, 10) des Gehäusevorderteils (5) umschließbar sind und
- mindestens einem Befestigungselement (3), mit welchem die Gehäuserückwand (2) mit dem Gehäusevorderteil (5) derart zu befestigen ist, daß wahlweise zum Aufbau des elektronischen Geräts als Handheld-Gerät die Vorderkanten (17) der Seitenwände (15, 16) der Gehäuserückwand (2) an der Rückseite des Randes (7) anliegen oder zum Einbau des elektronischen Geräts in einem geeigneten Ausschnitt einer Platte (4) der Ausschnittrand zwischen den Vorderkanten (17) der Seitenwände (15, 16) der Gehäuserückwand (2) und der Rückseite des Randes (7) eingeschlossen wird.

2. Elektronisches Gerät nach Anspruch 1, **dadurch gekennzeichnet,** daß
- die Rückseite des Randes (7) mit einer umlaufenden Dichtung (8) versehen ist.

3. Elektronisches Gerät nach Anspruch 1 oder 2, **dadurch gekennzeichnet,** daß
- an den hinteren Seitenwänden (9, 10) des Gehäusevorderteils (5) Federelemente (11) angeordnet sind, die im unmontierten Zustand seitlich herausragen.

4. Elektronisches Gerät nach Anspruch 3, **dadurch gekennzeichnet,** daß
- die Federelemente (11) als Rastverbindung ausgeführt sind, um beim Einbau des elektronischen Gerätes in einen geeigneten Ausschnitt einer Platte (4) diese zu hintergreifen.

5. Elektronisches Gerät nach einem der vorhergehenden Ansprüche, **dadurch gekennzeichnet,** daß
- Anschlußstellen (12, 13, 14) für externe Leitungen an einer oder mehreren hinteren Seitenwänden (9, 10) des Gehäusevorderteils (5) angeordnet sind und daß die Gehäuserückwand (2) in den Seitenwänden (15, 16) dazu korrespondierende Durchbrüche (19, 20, 21) aufweist.

6. Elektronisches Gerät nach Anspruch 5, **dadurch gekennzeichnet,** daß
- die Gehäuserückwand (2) als Bodenplatte ausgeführt ist.

7. Elektronisches Gerät nach einem der vorhergehenden Ansprüche, **dadurch gekennzeichnet,** daß
- es ein Bedienfeld eines Automatisierungsgeräts ist.

## Claims

1. Electronic device with a housing, comprising
- a front housing part (5) with an edge (7) adjacent to the front side (6) of the housing, which edge extends in a plane and projects laterally over the rear side walls (9, 10) of the front housing part (5),
- a cup-like rear housing wall (2), the side walls (15, 16) of which can enclose the rear side walls (9, 10) of the front housing part (5) and
- at least one fastening element (3) with which the rear housing wall (2) is to be fastened to the front housing part (5) in such a way that selectively to assemble the electronic device as a hand-held device the front edges (17) of the side walls (15, 16) of the rear housing wall (2) abut the rear of the edge (7) or, for the installation of the electronic device in a suitable segment of a plate (4), the segment edge is enclosed between the front edges (17) of the side walls (15, 16) of the rear housing wall (2) and the rear of the edge (7).

2. Electronic device according to claim 1, characterized in that the rear of the edge (7) is provided with a circumferential seal (8).

3. Electronic device according to claim 1 or 2, characterized in that at the rear side walls (9, 10) of the front housing part (5) spring elements (11) are arranged which project laterally in the non-mounted state.

4. Electronic device according to claim 3, characterized in that the spring elements (11) are designed as a catch connection so that, when installing the electronic device into a suitable segment of a plate (4), the elements engage behind the plate.

5. Electronic device according to one of the preceding claims, characterized in that connecting points (12, 13, 14) for external leads are arranged at one or more rear side walls (9, 10) of the front housing part (5) and in that the rear housing wall (2) in the side walls (15, 16) has openings (19, 20, 21) corresponding therewith.

6. Electronic device according to claim 5,
characterized in that the rear housing wall (2) is designed as a base plate.

7. Electronic device according to one of the preceding claims, characterized in that it is an operator panel of an automation device.

## Revendications

1. Appareil électronique comportant un boîtier, constitué
- d'une partie avant (5) de boîtier avec au voisinage de la face avant (6) du boîtier, un bord (7) qui s'étend dans un plan et qui dépasse latéralement des parois latérales arrière (9, 10) de la partie avant (5) du boîtier,
- d'une paroi arrière (2) de boîtier de type coupe dont les parois latérales (15, 16) peuvent enserrer les parois latérales arrière (9, 10) de la partie avant (5) du boîtier, et
- d'au moins un élément de fixation (3) à l'aide duquel la paroi arrière (2) du boîtier peut être fixée à la partie avant (5) du boîtier de telle sorte que, au choix, pour agencer l'appareil électronique en tant qu'appareil portatif, les bords avant (17) des parois latérales (15, 16) de la paroi arrière (2) du boîtier prennent appui sur la face arrière du bord (7), ou pour l'encastrement de l'appareil électronique dans une découpe appropriée d'une plaque (4), le bord de la découpe soit inséré entre les bords avant (17) des parois latérales (15, 16) de la paroi arrière (2) du boîtier et la face arrière du bord (7).

2. Appareil électronique selon la revendication 1, caractérisé par le fait que
- la face arrière du bord (7) est munie d'un joint circonférenciel (8).

3. Appareil électronique selon la revendication 1 ou 2, caractérisé par le fait que
- des éléments à ressort (11) sont disposés sur les parois latérales arrière (9, 10) de la partie avant (5) du boîtier, qui dépassent latéralement à l'état non monté.

4. Appareil électronique selon la revendication 3, caractérisé par le fait que
- les éléments à ressort (11) sont réalisés sous la forme d'une liaison d'encliquetage pour, lorsque l'appareil électronique est encastré dans une découpe appropriée d'une plaque (4) , passer derrière cette plaque.

5. Appareil électronique selon l'une des revendications précédentes, caractérisé par le fait que
- des points de raccordement (12, 13, 14) pour des lignes externes sont prévus dans une ou plusieurs parois latérales arrière (9, 10) de la partie avant (5) de boîtier, et qu'à cet effet la paroi arrière (2) du boîtier comporte des évidements (19, 20, 21) correspondants dans les parois latérales (15, 16).

6. Appareil électronique selon la revendication 5, caractérisé par le fait que
- la paroi arrière (2) du boîtier est réalisée sous la forme d'une plaque de fond.

7. Appareil électronique selon l'une des revendications précédentes, caractérisé par le fait que
- il est un panneau de commande d'un appareil d'automatisation.
